# EUROPEAN PATENT APPLICATION

(11) **EP 3 933 942 A1**
(43) Date of publication of application: **05.01.2022**
(21) Application number: 20762727.4
(22) Date of filing: 21.02.2020
(51) Int. Cl.: H01L 33/48, H01L 21/677, H01L 21/683

(54) **ADHERING DEVICE, TRANSFER DEVICE USING SAME, AND TRANSFER METHOD**

(30) Priority: 28.02.2019 JP 2019035199; 19.02.2020 JP 2020026323
(71) Applicant: Nitto Denko Corporation, Ibaraki-shi, Osaka 567-8680 (JP)
(72) Inventor: YAMADA, Yasumi, Ibaraki-shi, Osaka 567-8680 (JP)
(74) Representative: Müller-Boré & Partner Patentanwälte PartG mbB
(86) International application number: PCT/JP2020/007206
(87) International publication number: WO 2020/175401

(57) **Abstract**

An adherent device capable of holding and releasing an object with a simple structure, and a transfer technique using the same are provided. An adherent device has a support member with at least one aperture, and a polymer material layer provided on a first principal surface side of the support member, in which an adhesive strength on a second principal surface of the support member on a side opposite the first principal surface changes by applying an external force.

## Description

### TECHNICAL FIELD

The present invention relates to an adherent device, transfer equipment using the same, and a transfer method.

### BACKGROUND ART

Electronic equipment like a display device is manufactured by dicing a wafer into semiconductor chips such as light emitting diodes (LEDs), and by mounting the individual chips in a given layout on a circuit board. In general, the chip pitch immediately after being diced from the wafer differs from the pitch on the circuit board in which the diced chips are mounted in a predetermined layout. The chips diced from the wafer are picked out one by one and placed at the predetermined positions on the circuit board.

To avoid the troublesome work to individually transfer and mount the chips, several configurations have been proposed to pick multiple chips at a time and place them onto desired positions.

One of known configurations is to pick and hold a plurality of chips arranged with a first pitch on the first substrate, by means of an adhesive sheet, and to release the chips onto the second substrate by irradiating the sheet with ultraviolet rays. (See, for example, Patent Document 1.) In this technique, a mask having apertures formed with a second pitch is used to irradiate the chips with the ultraviolet rays through the mask from the back side of the pressure-sensitive adhesive sheet to release the chips.

A method of picking a plurality of microdevices, which are arrayed on a carrier board via an adhesive layer, using an array of electrostatic transfer heads, and of transferring them onto a circuit board is also known. (See, for example, Patent Document 2.) In this method, the phase of the adhesive layer on the carrier board is changed from the solid phase to the liquid phase prior to picking out the microdevices, and a voltage is applied to the electrostatic transfer heads to produce a grip force for holding the microdevices. By selectively switching off the grip force of the transfer heads above the circuit board, desired microdevice(s) is/are placed onto the circuit board.

Still another known configuration is bonding a plurality of semiconductor chips together with the carrier board onto an adhesive sheet, heating the adhesive sheet after removal of the carrier board to reduce the adhesive strength, and then picking the semiconductor chips from the sheet using a vacuum suction head. (See, for example, Patent Document 3.) The semiconductor chips held by vacuum adsorption are placed onto a circuit board by turning off the vacuum suction.

### PRIOR ART DOCUMENTS

Patent Document 1: JP Patent No. 4000856
Patent Document 2: JP Patent No. 5783481
Patent Document 3: JP Patent Application Laid-open Publication No. 2018-32740

### SUMMARY OF THE INVENTION

### <TECHNICAL PROBLEM TO BE SOLVED>

The method disclosed in Patent Document 1 requires extra steps of mask arrangement on the back surface of the adhesive sheet, and of laser irradiation for releasing the chips from the adhesive sheet. Chip placement onto the second substrate is restricted by the aperture pattern of the mask, which is inflexible.

In the method of Patent Document 2, a large number of mesa-shaped structures are formed inside the transfer head, and the configuration of the transfer head is complicated. Besides, the adhesive remains on the surface of the transported microchips.

In the method of Patent Document 3, a heater is built in each of the electrostatic transfer heads to control the temperature of the semiconductor chip picked out by that transfer head, and the configuration of the transfer head is complicated. Besides, the adhesive remains on the surface of the semiconductor chips.

An objective of the invention is to provide an adherent device capable of holding and releasing an object with a simple structure, and provide a transferring technique using such an adherent device.

### <SOLUTION TO SOLVE THE TECHNICAL PROBLEM>

In an embodiment of the invention, an adherent device includes a support member having at least one aperture, and a polymer material layer provided on a side of a first principal surface of the support member, wherein an adhesive strength on a second principal surface on a side opposite the first principal surface of the support member varies by application of an external force.

In another embodiment, a transfer equipment includes an adherent device which has a support member with at least one aperture, and a polymer material layer provided on a side of a first principal surface of the support member, an adhesive strength on a second principal surface on a side opposite the first principal surface of the support member being varied by application of an external force,
a driving mechanism configured to move the adherent device between a first position and a second position, and
a controller that controls a timing of application of the external force, thereby changing the adhesive strength of the second principal surface of the support member between the first position and the second position to transport an object between the first position and the second position.

### <ADVANTAGEOUS EFFECT OF THE INVENTION>

According to the above-described configuration of the adherent device, an object can be held and released with a simple structure. The transfer equipment using this adherent device can pick out a desired object, move it to a desired position, and place it by a simple control scheme.

### BRIEF DESCRIPTION OF DRAWINGS

FIG. 1 shows a basic configuration of an adherent device according to an embodiment;
FIG. 2 shows the states of the polymer material layer when no external force is applied;
FIG. 3 shows examples of deformation of the polymer material layer under an external force applied;
FIG. 4 shows an example of driving an adherent device by applying a voltage;
FIG. 5 shows a modification of the adherent device operating by applying a voltage;
FIG. 6 shows an example of driving an adherent device by applying heat;
FIG. 7 shows an example of driving an adherent device by applying pressure;
FIG. 8 shows another example of changing the adhesive strength on the surface of the support member by applying an external force;
FIG. 9 shows still another example of changing the adhesive strength on the surface of the support member by applying an external force;
FIG. 10 is a schematic diagram of a transfer equipment using the adherent device according to an embodiment;
FIG. 11 shows a process of transferring an article using the transfer equipment;
FIG. 12 shows an example of an adherent device having an array of a plurality of adhesive bodies;
FIG. 13 shows an example of driving an adherent device having an array of a plurality of adhesive bodies;
FIG. 14 shows voltage control on an adherent device;
FIG. 15 shows an example of wiring formed on the support member;
FIG. 16 shows deformation of a polymer material layer by applying a voltage;
FIG. 17 shows an example of heat control on an adherent device;
FIG. 18 shows an example of pressure control on an adherent device;
FIG. 19 shows an application to a micro LED transfer process;
FIG. 20 shows an example of transporting LED chips by a transfer equipment;
FIG. 21 shows an example of transporting chips by a transfer equipment;
FIG. 22 is a schematic diagram of test equipment for evaluating the adhesive strength of an adherent device;
FIG. 23 shows a procedure for evaluating the adhesive strength of the adherent device;
FIG. 24 shows a measurement result using the test equipment;
FIG. 25 shows a relationship between the applied voltage and the adhesive strength;
FIG. 26 shows a relationship between the height of protrusion of an adhesive body and the adhesive strength.

### DEDESCRIPTION OF EMBODIMENTS

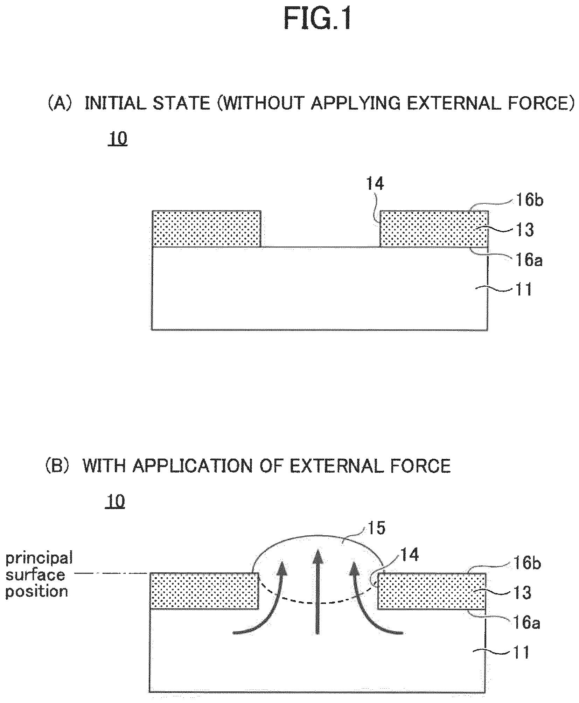

FIG. 1 shows a basic configuration of an adherent device 10 according to an embodiment. In the embodiment, a polymer material layer deformable by application of an external force is used. The adhesive or holding strength with respect to an object is controlled by regulating the adhesive strength on a surface of a support member.

The adherent device 10 has a support member 13 having one or more apertures 14, and a polymer material layer 11 provided adjacent to the first principal surface 16a of the support member 13. By applying an external force, the adhesive strength on the second principal surface 16b, on the other side of the first principal surface 16a, changes.

The change in the adhesive strength due to application of the external force includes:
(a) the adhesive strength increasing from zero on the second principal surface 16b;
(b) the adhesive strength changing from low to high on the second principal surface 16b;
(c) the adhesive strength changing from high to low on the second principal surface 16b; and
(d) the adhesive strength decreasing to zero on the second principal surface 16b.

The configuration of FIG. 1 shows the mode (a) in which the adhesive strength increases from zero on the second principal surface 16b of the support member 13 by applying an external force. Any one of the four modes (a) to (d) can be achieved using the support member 13 having an aperture 14, and the polymer material layer 11.

FIG. 1 (A) shows the initial state in which no external force is applied. Without an external force applied, the polymer material layer 11 stays on the side of the first principal surface 16a of the support member 13. The polymer material layer 11 is an adherent polymer which is deformable by applying an external force. The support member 13 is made of a non-adherent material in this example.

In FIG. 1 (B), upon applying of an external force, the polymer material layer 11 protrudes beyond the position of the second principal surface 16b of the support member 13 (indicated as "principal surface position" in the figure), and an adhesive body 15 is formed on the second principal surface 16b. The external force is, for example, a voltage, heat, pressure, or the like; however, it is not limited to these examples. The height of the adhesive body 15 can be regulated by adjusting the level of the applied external force.

Although in FIG. 1 a non-adherent support member 13 and an adherent polymer material layer 11 are used, a support member 13 having an adherent property lower than the polymer material layer 11 may be used. In the latter case, the mode (b) in which the adhesive strength changes from low to high on the second principal surface 16b is achieved.

The modes (c) and (d) can also be achieved by combining different properties of the support member 13 and the polymer material layer 11, or by setting a different state for the initial state, as will be more particularly described below.

The aperture 14 formed in the support member 13 may have any suitable shape including a circle, an ellipse, and a polygon, which can be selected according to the purpose or application. The dimension(s) of the aperture 14 may be designed according to the size of the object to be held. To pick and hold a semiconductor chip of 10 µm × 10 µm with a height of several microns, the diameter of the aperture 14 may be set to 10 µm to 15 µm so as to reversibly produce the adhesive body 15 on the second principal surface 16b to pick and release the semiconductor chip.

The adherent device 10 is applicable not only to picking semiconductor chips, but also to medical-use micro tweezers, assembling of optical precision components, etc. The size and the shape of the aperture 14 can be designed according to the applications, or the size and/or the weight of the object to be held. The diameter of the aperture 14 may be several microns to several hundred microns. By setting the diameter of the aperture 14 in this range, the polymer gel of the polymer material layer 11 can effectively deform under the application of an external force to produce the adhesive body 15 on the second principal surface 16b.

The polymer material layer 11 may be formed of a gelatinous polymer material by a casting method or the like. For the polymer material, polyvinyl chloride (PVC), polymethylmethacrylate, polyurethane, polystyrene, polyvinyl acetate, polyvinyl alcohol, polycarbonate, polyethylene terephthalate, polyacrylonitrile, silicone rubber, etc. can be used.

The adherent device 10 is fabricated by providing the support member 13 with the aperture 14 onto the polymer material layer 11. When the polymer material contains a solvent, the support member 13 may be provided after the solvent is evaporated by natural drying in the coated state. Because the polymer material layer 11 is gelatinous or a viscoelastic semi-solid, a layered structure can be obtained simply by placing the support member 13 onto the polymer material layer 11.

The thickness of the polymer material layer 11 is appropriately determined according to factors such as the thickness and the weight of the support member 13, the size of the aperture 14, or the target height of the adhesive body 15 to be produced. In one example, the thickness of the polymer material layer 11 is 1 mm or less, preferably 0.1 mm to 0.5 mm. The polymer material layer 11 having a thickness of this range is easy to handle; however, the thickness of the polymer material layer 11 may be 0.1 mm or less in consideration of the aperture size of the support member 13. For instance, in the case of forming an array of a number of small adhesive bodies 15 on the second principal surface 16b of the support member 13, the thickness of the polymer material layer 11 may be set to 0.1 mm or less.

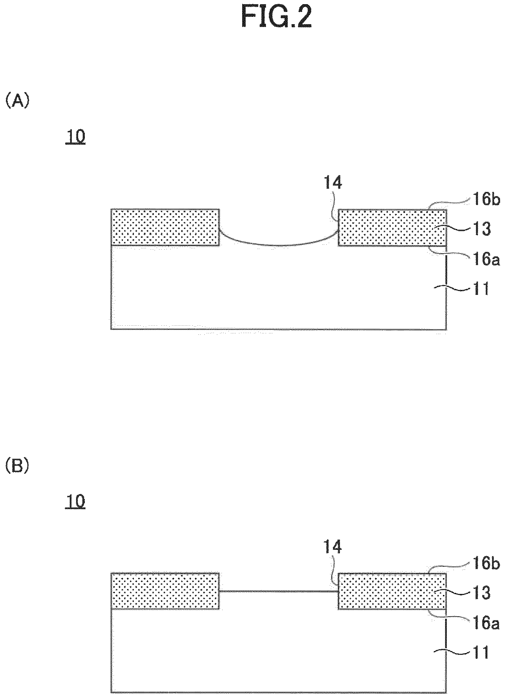

FIG. 2 shows the states of the polymer material layer 11 staying on the side of the first principal surface 16a without application of an external force. The polymer material layer 11 does not have to be always flat, aligning with the first principal surface 16a, as illustrated in FIG. 1 (A), when no external force is applied.

As illustrated in FIG. 2 (A), the surface of the polymer material layer 11 may be concave within the aperture 14, the periphery being pulled up along the inner wall of the aperture 14. Alternatively, the polymer material layer 11 may enter the aperture 14 up to the height near the second principal surface 16b, as illustrated in FIG. 2 (B). In the states of FIG. 2 (A) and (B), the adhesiveness of the polymer material layer 11 does not affect the adhesive strength of the second principal surface 16b of the support member 13.

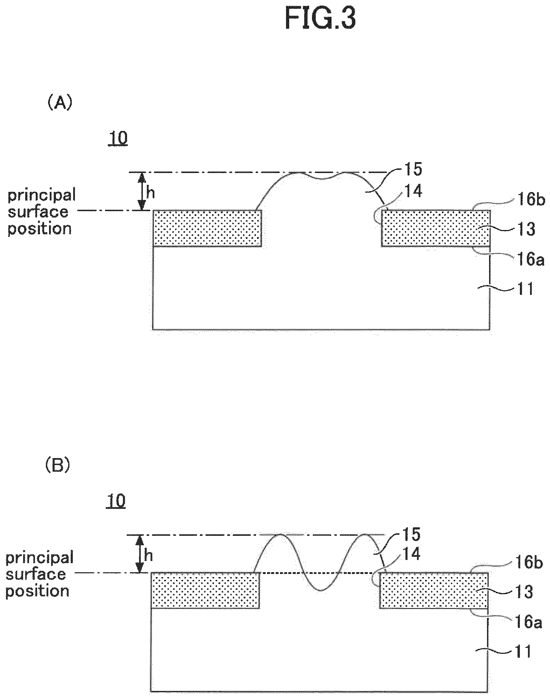

FIG. 3 shows the states of the adhesive body 15 produced on the second principal surface 16b when an external force is applied. The shape of the adhesive body 15 formed on the second principal surface 16b is not limited to the convex shape illustrated in FIG. 1 (B). As long as the adhesive strength of the second principal surface 16b can change, the apex of the adhesive body 15 may be flat or slightly depressed at the center, as illustrated in FIG. 3 (A). The adhesive body 15 may protrude higher along the circumference of the aperture 14 beyond the second principal surface 16b, while the center portion remains in the aperture 14 without reaching the second principal surface 16b, as illustrated in FIG. 3 (B). In this specification and claim, the term "higher" or "lower" indicates a positional relation with respect to the layered direction of the polymer material layer 11 and the support member 13.

### <CONFIGURATION EXAMPLE OF VOLTAGE APPLICATION>

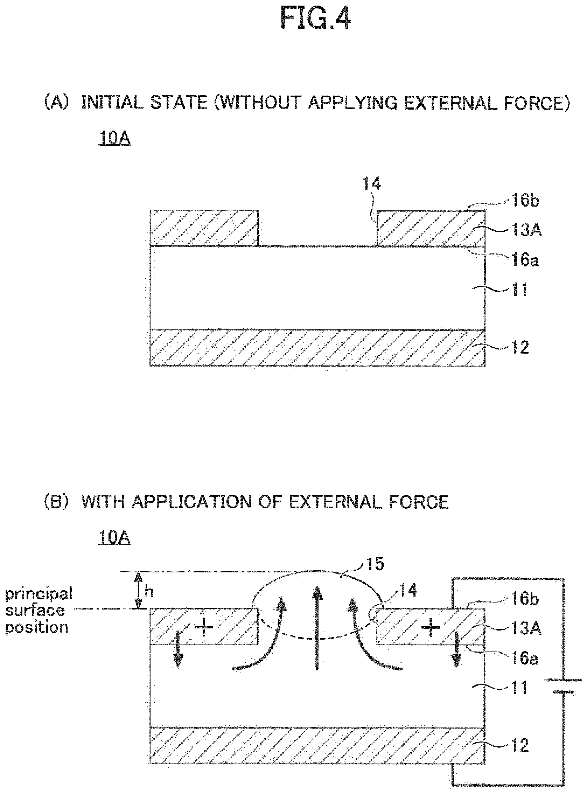

FIG. 4 shows a configuration of an adherent device 10A operated by applying a voltage as the external force. The polymer material layer 11 deforms by application of a voltage, and an adhesive body 15 is reversibly produced on the second principal surface 16b of the support member 13A.

In the adherent device 10A, a conductive film 12, the polymer material layer 11, and the support member 13A having an aperture 14 are laminated in this order. The conductive film 12 serves as a bottom electrode. The support member 13A is formed of a conductive material and serves as a top electrode.

As the polymer material layer 11, a polymer gel deformable, namely, capable of generating dielectric polarization in response to voltage application is used. PVC, which exhibits adequate deformation under the effect of the electric field and is easy to handle, may be used. As an alternative, polymethyl methacrylate, polyurethane, polystyrene, polyvinyl acetate, polyvinyl alcohol, polycarbonate, polyethylene terephthalate, polyacrylonitrile, silicone rubber, or other polymer materials may be used.

An ionic liquid may be added to the polymer gel at a predetermined weight ratio. By adding a predetermined amount of ionic liquid, the voltage level can be reduced, while improving the efficiency of deformation. For example, by adding an ionic liquid of a weight percentage from 0.2 wt% to 1.5 wt%, more preferably 0.3 wt% to 1.0 wt%, the voltage for driving the polymer material layer 11 can be reduced.

As an ionic liquid, 1-ethyl-3-methylimidazolium tetrafluoroborate (EMI-BF4), 1-octyl-3-methylimidazolium tetrafluoroborate (OMI-BF4), 1-ethyl-3-methylimidazolium dicyanamide (EMI-DCA), and tetrabutylphosphonium tetrafluoroborate (TBP-BF4) can be used.

An appropriate plasticizer may be added to the polymer gel. Such a polymer gel may be dissolved in a solvent. For the plasticizer, dibutyl adipate (DBA), diethyl adipate (DEA), diethyl sebacate (DES), dioctyl phthalate (DOP), diethyl phthalate (DEP), and so on can be used. As the solvent, an ether solvent such as tetrahydrofuran (THF) can be used.

The materials of the conductive film 12 and the support member 13 are not particularly limited as long as they have electrical conductivity. If the conductive film 12 and/or the support member 13 are/is made of a metal, platinum (Pt), gold (Au), silver (Ag), nickel (Ni), chromium (Cr), copper (Cu), titanium (Ti), tantalum (Ta), indium (In), palladium (Pd), lithium (Li), niobium (Nb), or alloys thereof may be used. Conductive polymers, conductive carbon materials or the like may also be used for the conductive film 12 and/or the support member 13. In the example of FIG. 4, the conductive film 12 is a cathode and the support member 13 is an anode.

FIG. 4 (A) shows a state in which no voltage is applied. The conductive film 12 and the support member 13 are in surface contact with the polymer material layer 11. The polymer material layer 11 does not protrude from the second principal surface 16b of the support member 13. As described above, the surface of the polymer material layer 11 does not have to be flat in the aperture 14.

In FIG. 4 (B), when a voltage is applied between the conductive film 12 and the support member 13, electrons are injected into the polymer material layer 11 from the conductive film 12 serving as the cathode. On the other hand, the inner wall of the aperture 14 of the support member 13, serving as the anode, is positively charged. The polymer material layer 11 containing electrons is attracted to the inner wall of the aperture 14 of the support member 13.

When an ionic liquid is added to the polymer material layer 11, the polymer material layer 11 is more effectively attracted to the inner wall of the aperture 14 because of the presence of anions (negative ions) with a predetermined transport number contained in the ionic liquid. Due to the elasticity of the gel, the polymer material layer 11 is compressed in the fine aperture 14, pushed up through the aperture 14, and then protrudes from the second principal surface 16b of the support member 13 to form the adhesive body 15. This deformation of the polymeric material layer 11 is caused by the voltage response characteristics, making use of the elasticity of the gel. The formation of the adhesive body 15 on the second principal surface 16b imparts an adhesive strength to the second principal surface 16b.

The deformation of the polymer material layer 11 is reversible, and the initial state shown in FIG. 4 (A) can be restored by stopping the voltage application. The adhesive body 15 returns to the side of the first principal surface 16a of the support member 13, and the adhesive strength of the second principal surface 16b is eliminated or reduced. As a result, an object can be detachably held on the second principal surface 16b. Almost no adhesive remains on the surface of the object.

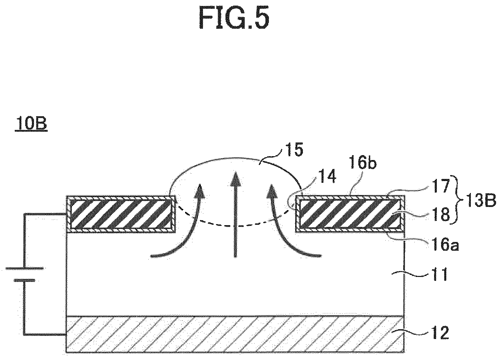

FIG. 5 shows the adherent device 10B as a modification of the configuration of FIG. 4, in which the adhesive strength changed by application of a voltage. In the adherent device 10B, the support member 13B is formed of an insulating sheet 18, and both sides of the insulating sheet 18 and the inner wall of the aperture 14 are covered with a conductive film 17.

Although in the example of FIG. 5, the conductive film 17 is formed so as to cover the entire surface of the insulating sheet 18, it is unnecessary to entirely cover the first principal surface 16a and the second principal surface 16b with the conductive sheet 18. Covering at least the surroundings of the aperture 14 with the conductive film 17 is sufficient. The area of the conductive film 17 that covers the first principal surface 16a may be greater than the area of the conductive film 17 that covers the second principal surface 16b. This configuration can promote the dielectric polarization of the polymer material layer 11.

Using the conductive film 17 formed on the support member 13B as the anode, the adhesive body 15 can be produced on the second principal surface 16b upon application of a voltage. By turning off the applied voltage, the adhesive body 15 returns to the first principal surface 16a side. The adhesive strength of the second principal surface 16b decreases, and the object having been held is released.

### <CONFIGURATION EXAMPLE OF HEAT APPLICATION>

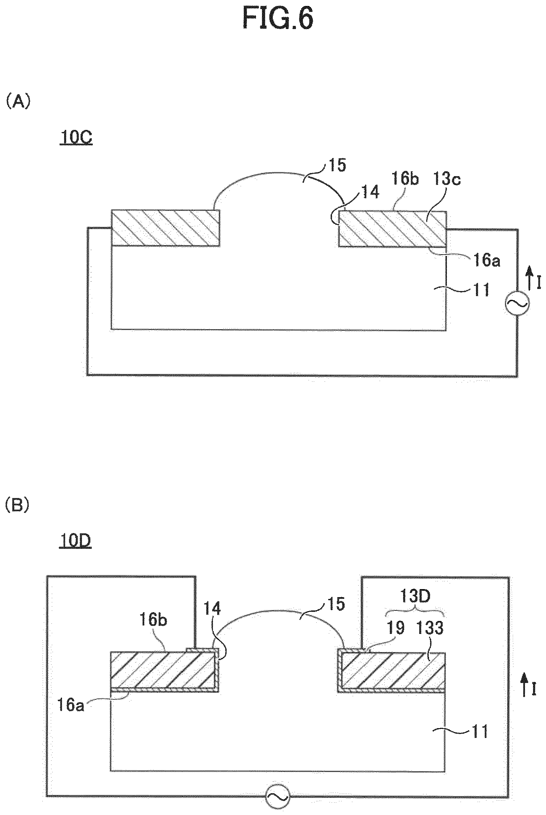

FIG. 6 shows a configuration example of an adherent device operating by applying heat as the external force. The polymer material layer 11 is deformable in response to heat, and the adhesive body 15 is reversibly produced on the second principal surface 16b of the support member 13C, by application of heat.

In FIG. 6 (A), the adherent device 10C has a polymer material layer 11 and a support member 13C with an aperture 14 layered in this order. The support member 13C is made of a thermally conductive material and configured to generate heat by injection of an electric current. By using a thermally conductive metal, an electric current can be directly injected into the support member 13C to cause electric resistance heating. In this case, Ni, Cr, Al, Mo, W, Pt or the like can be used as the metallic heating element.

When a non-metal heating element is used, carbon black, silicon carbide (SiC), molybdenum silicide (MoSi2), zirconium oxide (ZrO2), lanthanum chromite (LaCrO3), or a composite of graphite, copper (Cu) and aluminum (Al) may be used. With a non-metal heating element, an electrode for current injection may be provided on the surface of the support member 13C.

For the polymer material layer 11, a polymer gel whose fluidity increases by heating is used. For example, a thermoplastic resin such as polymethyl methacrylate, polyvinyl chloride, polyurethane, polystyrene, polyvinyl acetate, polyvinyl alcohol, polycarbonate, polyethylene terephthalate, polyacrylonitrile, silicone rubber, or other suitable polymers may be used.

The polymer material layer 11 deforms by application of heat from the support member 13C, and the adhesive body 15 is produced on the second principal surface 16b. As a result, the adhesive strength on the second principal surface 16b increases. By turning off the current injection, heating is stopped and the adhesive body 15 returns into the aperture 14. The adhesive strength of the second principal surface 16b decreases or becomes zero.

FIG. 6 (B) shows an adherent device 10D as a modified configuration. In the adherent device 10D, a thermally conductive layer 19 is formed on the support member 13D at least surrounding the aperture 14. The main body 133 of the support member 13D is made of an electrically insulating resin material having high thermal conductivity. The area covered with the thermally conductive layer 19 on the first principal surface 16a of the support member 13D may be greater than the area covered with the thermally conductive layer 19 on the second principal surface 16b.

The thermally conductive layer 19 is formed of, for example, Ni, Cr, Al, Mo, W, Pt, and so on. By switching on and off applying the heat to the polymer material layer 11, the adhesive body 15 protrudes on or retreats from the second principal surface 16b of the support member 13D, which can change the adhesive strength of the second principal surface 16b.

### <CONFIGURATION EXAMPLE OF PRESSURE APPLICATION>

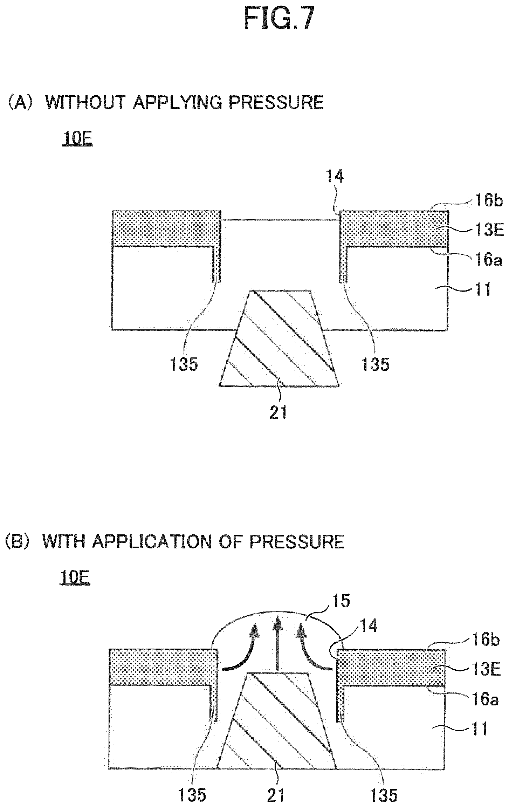

FIG. 7 shows a configuration example of an adherent device 10E operating by applying a pressure as the external force. The polymer material layer 11 deforms by applying pressure, and the adhesive body 15 is reversibly produced on the second principal surface 16b of the support member 13E.

In FIG. 7 (A), the adherent device 10E has a support member 13E with an aperture 14, a polymer material layer 11 provided on the side of the first principal surface 16a of the support member 13E, and a piston 21 which serves as a pressure applying mechanism. In the first principal surface 16a of the support member 13E, a cylinder shell 135 is formed around the aperture 14. The cylinder shell 135 is not limited to cylindrical, and it may be a polygonal shell surrounding the aperture 14.

In FIG. 7 (B), as the piston 21 rises, pressure is applied to the polymer material layer 11 inside the cylinder shell 135. With the pressure applied, the adhesive body 15 is produced on the second principal surface 16b, and the adhesive strength of the second principal surface 16b increases. The piston 21 may be connected to a pressurizing/depressurizing pump, or an air compressor/regulator, or it may be connected to a mechanical driving structure.

When the piston 21 descends to reduce the pressure in the cylinder shell 135, the adhesive body 15 retreats inside the aperture 14. As a result, the adhesive strength on the second principal surface 16b decreases.

### <CHANGE IN ADHESIVE STRENGTH ON SECOND PRINCIPAL SURFACE>

In the foregoing configurations, the initial state is set such that the polymer material layer 11 stays under the second principal surface 16b in the layered direction, and that the adhesive body 15 protrudes beyond the second principal surface 16b by applying an external force and increases the adhesive strength of the second principal surface 16b. The invention includes other configurations in which the initial state is set so as to have a greater adhesive strength and the adhesive strength of the second principal surface 16b decreases by application of an external force.

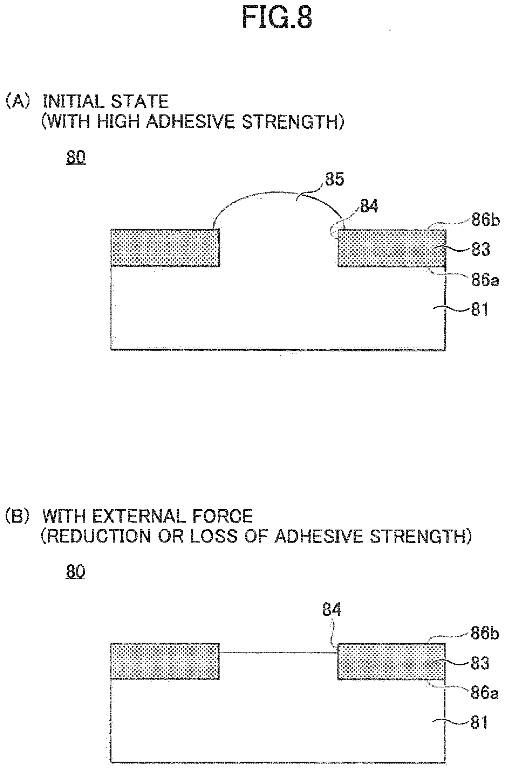

FIG. 8 shows a configuration example of an adherent device 80 having the initial state with a greater adhesive strength. The adherent device 80 has a support member 83 with an aperture 84, a polymer material layer 81 provided on the side of the first principal surface 86a of the support member 83, and an adhesive body 85 which changes the adhesive strength of the second principal surface 86b of the support member 83. The polymer material layer 81 is an adherent polymer gel deformable by application of an external force.

In the initial state of FIG. 8 (A), the adhesive body 85 is present on the second principal surface 16b of the support member 83, and the adhesive strength of the second principal surface 86b is high. The support member 83 may be non-adherent, or it may be made of a material having less adhesivenss than the polymer material layer 81. In the initial state, the adherent device 80 is able to hold an object by the adhesive body 85.

In FIG. 8 (B), upon application of an external force, the polymer material layer 81 contracts, and the adhesive body 85 retreats inside the aperture 84, being pulled toward the first principal surface 86a. As a result, the adhesive strength of the second principal surface 86b decreases.

In the case of using the configuration of FIG. 8, the object can be picked and held by the adhesive body 85 in the initial state. An external force is applied at a desired position to hold back the adhesive body 85, whereby the object is released. The external force may be voltage, heat, pressure or other forces. Depending on the external force to be applied, any one of the configurations shown in FIG. 4 to FIG. 7 can be employed.

With the configuration of applying a voltage, a conductive film may be provided facing the support member 83, such that the polymer material layer 81 is sandwiched between them, and that the support member 83 and the conductive film are used as a cathode and an anode, respectively. By applying a voltage, anions (negative ions) produced or contained in the polymer material layer 81 are attracted to the conductive film, and the adhesive body 85 is restored into the aperture 84, being pulled toward the polymer material layer 81.

With the configuration of applying heat, the adhesive body 85 is held back from the initial state toward the first principal surface 86a, by using a polymer material that shrinks when heat is applied. With the configuration of applying a pressure, the adhesive body 85 is held back from the initial state toward the first principal surface 86a by means of vacuum suction.

In FIG. 8, an adherent polymer material and a non-adherent or low-adherent support member are used. An alternative is using an adherent support member combined with a non-adherent or low-adherent polymer material to change the adhesive strength of the second principal surface 86b.

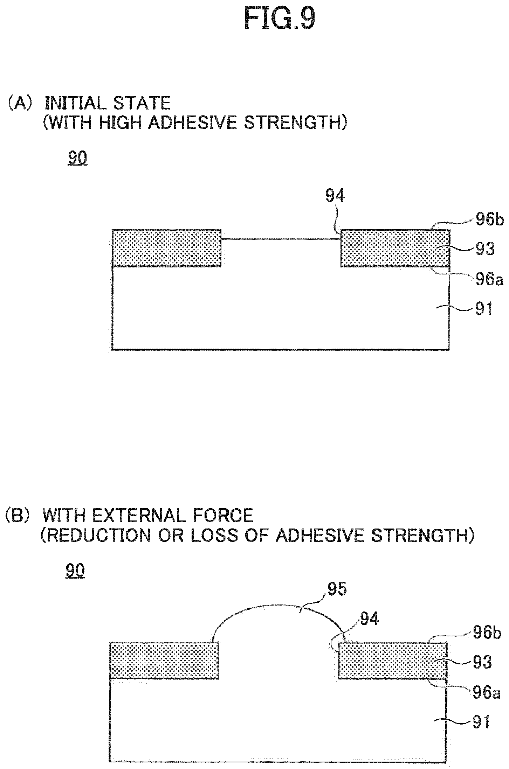

FIG. 9 is a schematic diagram of an adherent device 90. The adherent device 90 has a support member 93 with an aperture 94, a polymer material layer 91 provided on the side of the first principal surface 96a of the support member 93, and a protrusion 95 configured to change the adhesive strength of the second principal surface 96b of the support member 93.

The support member 93 is made of a material having an adhesiveness; or, at least the second principal surface 96b has an adhesiveness. For example, a material or a film having an adhesive strength with respect to semiconductors, metals or the like may be used.

The polymer material layer 91 is a polymer gel having little or very low adhesive strength and deformable in response to application of an external force. For the polymer material layer 91, polymethyl methacrylate, polyvinyl chloride, polyurethane, polystyrene, polyvinyl acetate, polyvinyl alcohol, polycarbonate, polyethylene terephthalate, polyacrylonitrile, silicone rubber, or other suitable polymer materials may be used.

In the initial state of FIG. 9 (A), the adhesiveness of the second principal surface 96b of the support member 93 is dominant, and an object having a size larger than the aperture 94 can be held by the second principal surface 96b.

In FIG. 9 (B), by applying an external force, a protrusion 95 of the polymer gel is formed on the second principal surface 96b. The object having been held on the second principal surface 96b is pushed by the protrusion 95, and detached from the second principal surface 96b.

Using the adherent device 90 of FIG. 9, the object is held on the second principal surface 96b of the support member 93 in the initial state, and an external force is applied at a desired position to form the protrusion 95 to release the object from the second principal surface 96b. The external force may be any one of voltage, heat, and pressure.

### <APPLICATION TO TRANSFER EQUIPMENT>

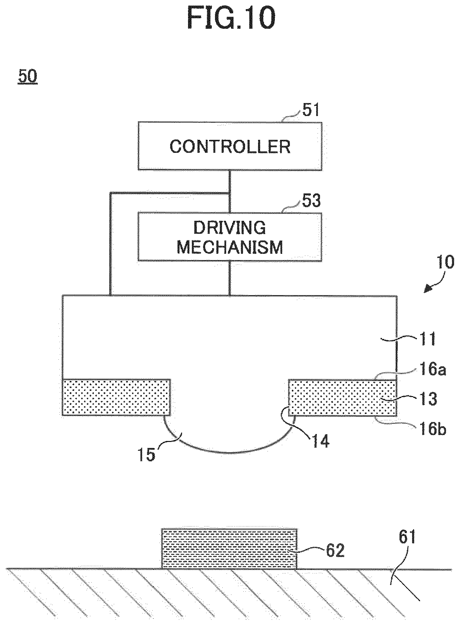

FIG. 10 is a schematic diagram of a transfer equipment 50 using the adherent device of an embodiment. The transfer equipment 50 includes an adherent device 10, a controller 51 that controls the timing of applying an external force to the adherent device 10, and a driving mechanism 53 that moves the adherent device 10. The controller 51 may control the operations of the driving mechanism 53.

In FIG. 10, the adherent device 10 is configured so that the adhesive strength on the second principal surface 16b of the support member 13 increases by applying an external force. In place of the adherent device 10, the adherent device 80 of FIG. 8, or the adherent device 90 of FIG. 9 may be used. The entirety of the adherent device 10, except for the second principal surface 16b, may be accommodated in a casing.

The transfer equipment 50 picks an object 62 from the stage 61 using the adherent device 10, transports the object 62, and then releases the object 62 at a predetermined position. If the adherent device 10 is of a voltage-driven type, the controller 51 controls the on/off timing of the voltage application to the adherent device 10 to produce or hold back the adhesive body 15 on or from the second principal surface 16b to change the adhesive strength of the second principal surface 16b. If the adherent device 10 is of a heat-driven type, the controller 51 controls the heating timing of the adherent device 10 to change the adhesive strength of the second principal surface 16b. If the adherent device 10 is of a pressure-driven type, the pressure-applying timing of the adherent device 10 is controlled by the controller 51 to change the adhesive strength of the second principal surface 16b.

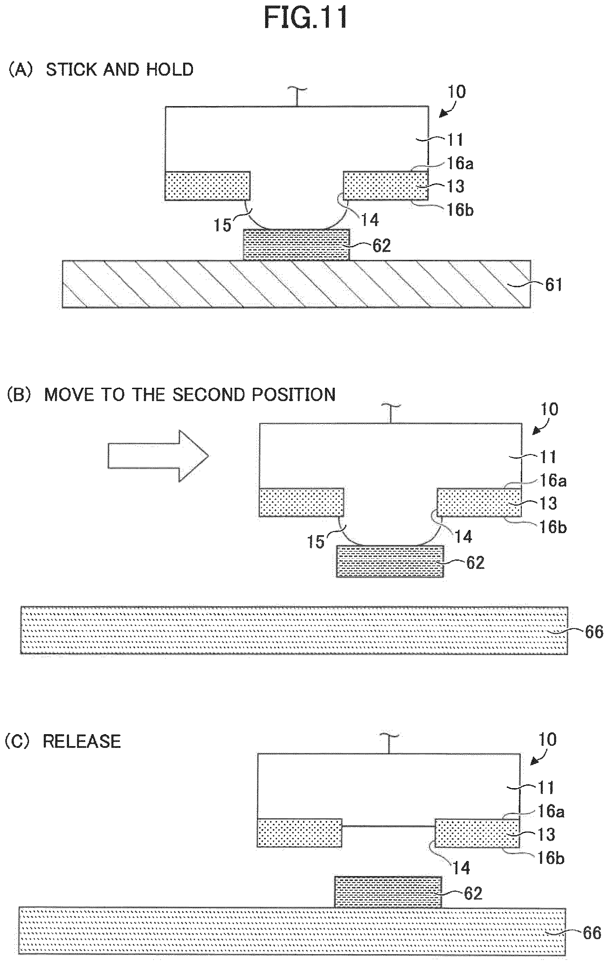

FIG. 11 shows a process of transferring the object 62. In FIG. 11 (A), the position of the aperture 14 of the adherent device 10 is aligned relative to the object 62, and an external force is applied to the adherent device 10. An adhesive body 15 produced on the second principal surface 16b of the support member 13 comes into contact with the object 62 on the stage 61.

In FIG. 11 (B), the object 62 is held by the adhesive body 15 and transported to the target substrate 66. In FIG. 11 (C), the external force is turned off at a predetermined position above the substrate 66 to hold back the adhesive body 15 toward the first principal surface 16a, and the object 62 is placed at the predetermined position in the substrate 66. In order to fix the object 62 to the substrate 66, an adhesive layer may be formed on the surface of the substrate 66 in advance.

The transfer equipment 50 is not limited to transport of inorganic objects such as semiconductors, metals, or insulators. It can also be used to transfer a biological tissue or a pseudo biological tissue to a predetermined site in or outside the living body. If an array of a number of adhesive bodies 15 is formed on the second principal surface 16b, a number of chips or minute objects can be transferred at a time.

### <EXPANSION TO ARRAY STRUCTURE>

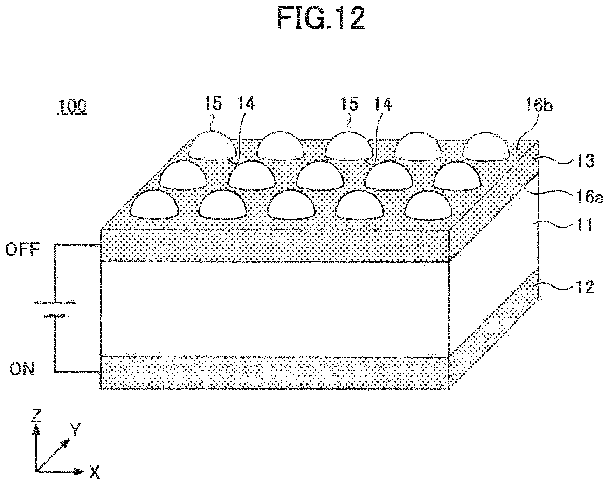

FIG. 12 is a schematic diagram of an adherent device 100 having an array of a number of adhesive bodies 15. The adherent device 100 has a support member 13 in which a plurality of apertures 14 are formed, and a polymer material layer 11 arranged on the side of the first principal surface 16a. A plurality of adhesive bodies 15 are formed on the second principal surface 16b upon application of an external force.

When a voltage is applied as the external force, as shown in FIG. 12, the polymer material layer 11 is sandwiched between the support member 13 and the conductive film 12. An electrical conductor is provided at least around the apertures 14 of the support member 13, and a voltage is applied between the conductive film 12 and the conductive area(s) of the support member 13. If the entirety of the support member 13 is formed of a conductor, an array of adhesive bodies 15 is produced collectively. It is also possible to provide a conductive area for each of the apertures 14 and individually control the application of voltage.

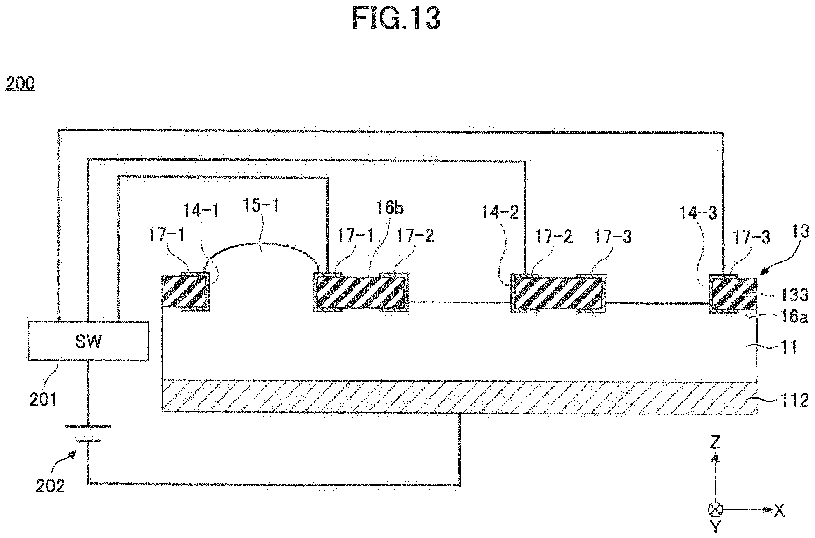

FIG. 13 shows an example of individual control on application of an external force. The adherent device 200 is, for example, of a voltage-driven type, and the polymer material layer 11 is provided between the support member 13 and the conductive film 112. The support member 13 has a main body 133 made of an insulator, and a number of apertures 14-1 to 14-n (only apertures 14-1 to 14-3 are shown in FIG. 13 for convenience) are formed in the main body 133. The outer periphery and the inner wall of the apertures 14-1 to 14-3 are covered with conductive films 17-1 to 17-3. The conductive films 17-1 to 17-3 are electrically insulated from one another, and individually connected to the switch (SW) 201. Each of the conductive films 17-1 to 17-3 serves as an electrode, and the conductive film 112 on the bottom serves as a common electrode.

By selecting aperture(s) 14 by the switch 201, the adhesive body/bodies 15 can be formed in the desired aperture(s) 14. In the example of FIG. 13, the aperture 14-1 is selected by the switch 201, and a voltage is applied to the conductive film 17-1 to form the adhesive body 15-1 on the second principal surface 16b.

Voltage is not applied to the conductive films 17-2 and 17-3 provided for the apertures 14-2 and 14-3, and the polymer material layer 11 stays on the side of the first principal surface 16a of the support member 13. The adhesive strength of the second principal surface 16b changes only around the aperture 14-1 to which the voltage is applied.

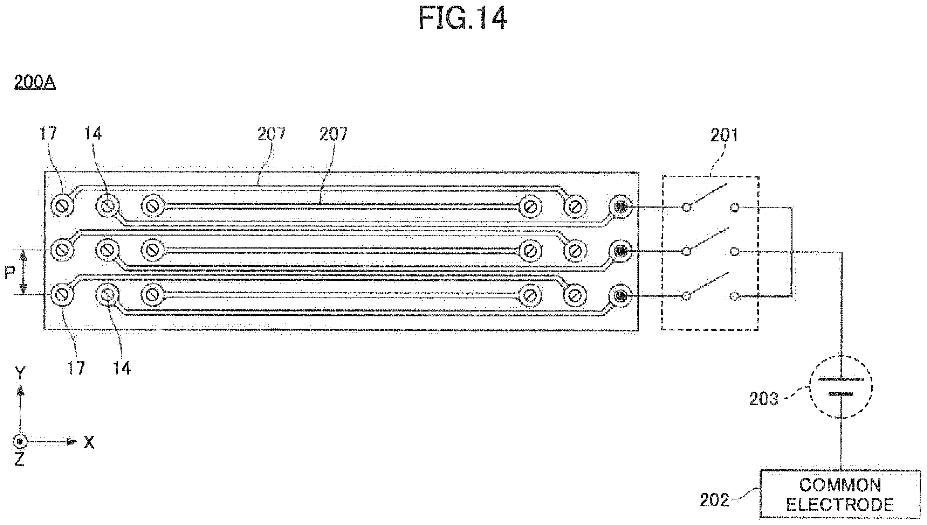

FIG. 14 shows voltage control on the adherent device 200A. In the adherent device 200A, wirings 207 for connecting the respective conductive films 17 to the switch 201 are formed on the support member 13. For simplifying the illustration, 3×3 apertures 14 are provided at a predetermined pitch P, and the three apertures in the center row are illustratively connected to the switch 201; however, all the apertures 14 are individually connected to the switch 201 in the actual configuration. Alternatively, a switch 201 may be provided for each row.

By controlling the on/off operation of the switch 201, a voltage can be applied to the selected aperture 14 to produce the adhesive body 15.

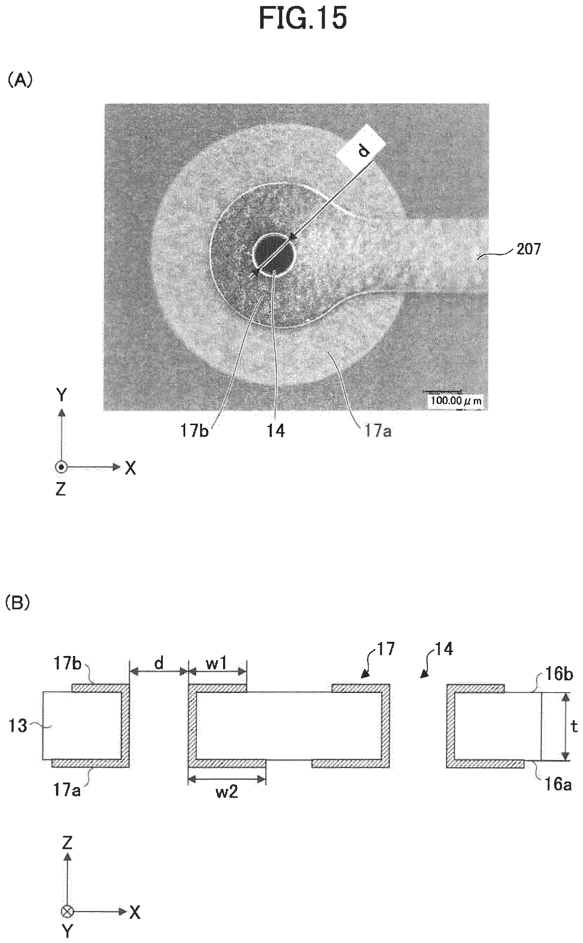

FIG. 15 shows an example of wirings formed on the support member 13. FIG. 15 (A) is an image of the actually fabricated wiring pattern, and FIG. 15 (B) is a schematic cross-sectional view of the support member 13. A polyimide with a film thickness "t" of 25 µm is used as the support member 13, and an aperture 14 with a diameter "d" of 100 µm is formed therein. The conductive film 17 is formed so as to continuously cover the inner wall of the aperture 14 and the surface area surrounding the aperture 14. The thickness of the conductive film 17 is, for example, about 6 to 12 µm.

The conductive film 17 includes a conductive area 17a surrounding the periphery of the aperture 14 at the first principal surface 16a of the support member 13, and a conductive area 17b surrounding the periphery of the aperture 14 at the second principal surface 16b. The wiring 207 extends from the conductive area 17b.

In this example, the width w2 of the conductive area 17a on the first principal surface 16a is set greater than the width w1 of the conductive area 17b on the second principal surface 16b. However, the present invention is not limited to this configuration. The conductive film 17 can be patterned into a desired form, as long as a sufficient quantity of dielectric polarization can be generated in the polymer material layer 11 in the vicinity of the selected aperture 14.

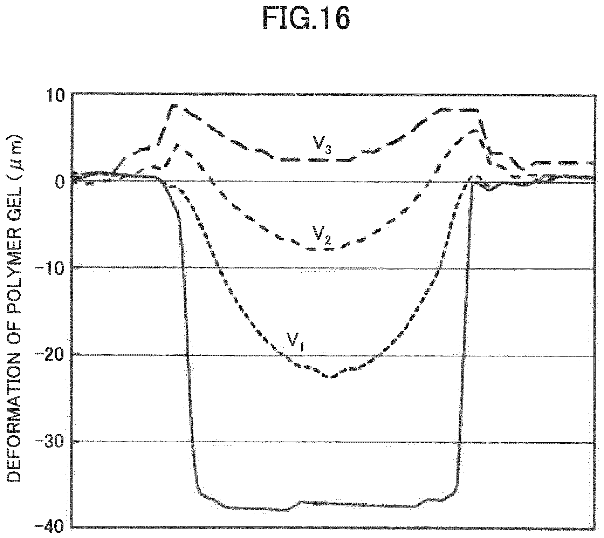

FIG. 16 shows deformation of the polymer material layer 11 at several voltage levels. The vertical axis of the figure represents the amount of deformation (µm) of the polymer gel. The minus sign corresponds to the depth direction of the aperture 14, and the value zero corresponds to the position of the second principal surface 16b of the support member 13. As the applied voltage is increased from V1 to V3, the polymer material layer 11 deforms and protrudes beyond the second principal surface 16b. This protruding portion becomes the adhesive body 15. By changing the applied voltage level, the height and/or the volume of the adhesive body 15 protruding from the second principal surface 16b can be controlled, and the adhesive strength can be changed.

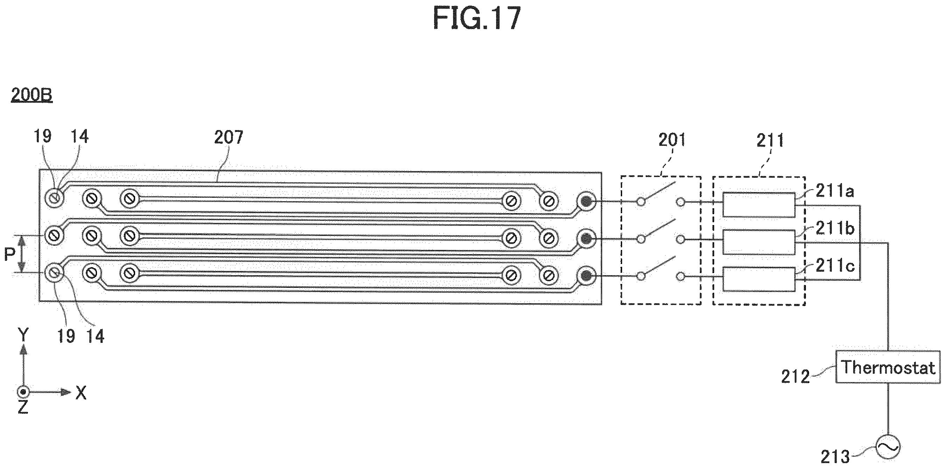

FIG. 17 shows heating control on an adherent device 200B. In the adherent device 200B, the heating state is controlled for each aperture using the heater 211 and the switch 201. For convenience of illustration, the three apertures of the 3x3 aperture pattern are connected to the heater 211 via the switch 201, but each of the apertures can be connected to the heater 211. The heater 211, which is an example of the heating means, has individual heating elements 211a to 211c, and the respective heating elements are connected to the current source 213 via the thermostat 212. Again, the present invention is not limited to this example, and any suitable configuration which enables to individually control the on/off operation of the heating for each of the apertures 14 can be employed.

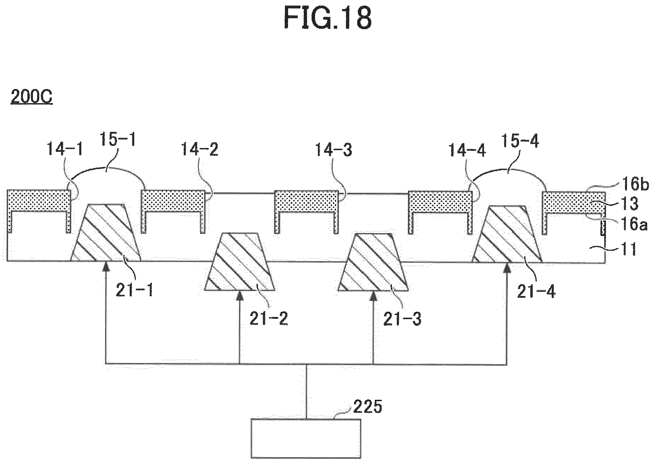

FIG. 18 shows pressure control on an adherent device 200C. In the adherent device 200C, the applied pressure is controlled for each aperture 14 using the pressure control means. In this example, the pressure control means includes pistons 21-1 to 21-4 provided for the respective apertures 14, and a driving means 225 for individually driving the pistons 21-1 to 21-4. The driving means 225 may be any suitable means which can individually drive the pistons 21-1 to 21-4. An air compressor, a vacuum or pressure pump or the like can be used as the driving means.

By controlling on and off of the pressure applied to each of the apertures 14 of the support member 13, the polymer material layer 11 deforms and produces the adhesive body/bodies 15 on the second principal surface 16b at the selected aperture(s) 14. For example, the pistons 21-1 and 21-4 are driven to apply pressure to the apertures 14-1 and 14-4 to form the adhesives bodies 15-1 and 15-4 on the second principal surface 16b. In the apertures 14-2 and 14-3 on the other hand, the polymer material layer 11 stays on the side of the first principal surface 16a without protruding.

The above-described individual control on the adherent array structure is applicable to a transfer equipment configured to transfer a plurality of objects. In the application to such a transfer equipment, the polymer material layer 11 may be an adhesive polymer so as to pick and hold the object(s) by adhesive body/bodies 15. Alternatively, the polymer material layer 11 may be a non-adherent or low adherent polymer, and a protrusion may be produced on the second principal surface 16b by applying an external force to release the object(s).

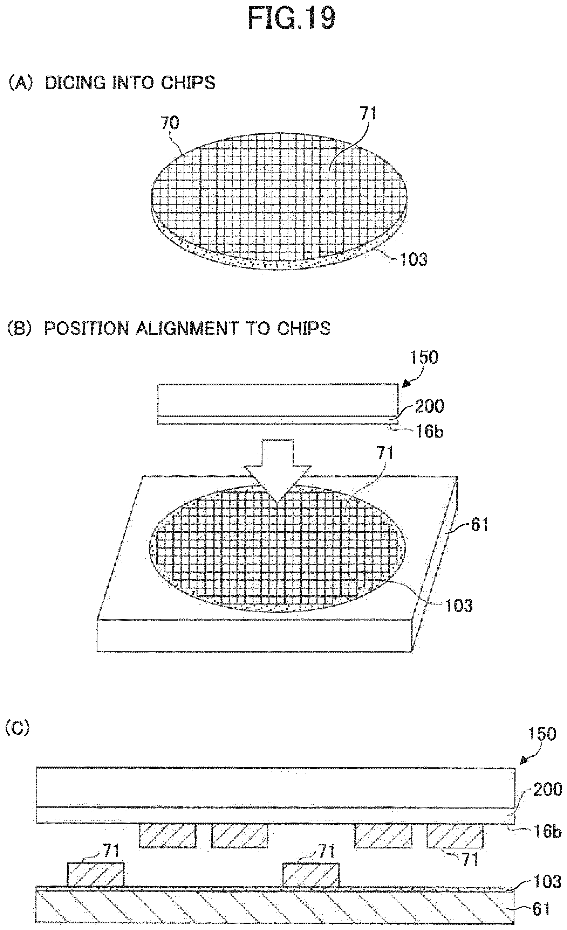

FIG. 19 shows an application of the adherent device 200 to a process of transferring micro LEDs. In FIG. 19 (A), a number of light emitting elements 71, which may be called "micro LEDs", are formed in the chip area of a semiconductor wafer 70. A micro LED is a fine chip of several-ten-micron squares, and each micro LED constitutes a sub-pixel of a display, while independently working as the light emitting element 71.

The light emitting elements 71 are cut out from the semiconductor wafer by dicing along the scribe lines, whereby individual chips are obtained. Any suitable dicing method such as stealth dicing, blade dicing, or anisotropic etching, may be employed to obtain individual chips. Stealth dicing may be a desirable method from the viewpoint of acquiring as many chips as possible from one wafer. The size of each light emitting element 71 is, for example, 100 µm × 200 µm. The semiconductor wafer 70 is temporarily attached onto a flat plane in advance, using a dicing tape 103 or the like, to prevent the chips from scattering during the dicing, and accordingly, the formation of the chips arrayed with a predetermined pitch is maintained even after the dicing.

In FIG. 19 (B), the transfer equipment 150 is positioned above the stage 61. The transfer equipment 150 has an adherent device 200 on the surface facing the stage 61, and the adhesive strength on the second principal surface 16b is controlled at each aperture 14. The adherent device 200 may be any one of the above-described adherent devices 200A to 200C. Furthermore, the adherent device 200 is not limited to the configuration in which the adhesive body 15 is formed by applying an external force, and the configuration of FIG. 8 or FIG. 9 in which the adhesive strength is reduced by applying an external force may be employed. In either case, the adhesive strength (or the tack strength) of the adherent device 200 for picking the light emitting element 71 from the stage 61 is greater than the adhesive strength of the dicing tape 103 maintaining the light emitting element 71 on the stage 61. After dicing of the wafer and before picking out by the transfer equipment 150, the dicing tape may be exposed to heat, light (ultraviolet rays, for example), or the like to reduce or eliminate the adhesive strength in order to facilitate the picking action from the dicing tape.

Instead of directly picking out the light emitting element(s) 71 from the stage 61, the light emitting elements 71 may be rearranged onto another stage with a different pitch. Then, desired light emitting element(s) 71 may be picked out by the transfer equipment 150.

In FIG. 19(C), the desired light emitting elements 71 are picked out by the adherent device 200. If the light emitting elements 71 are rearranged so as to match the pitch of the apertures 14 (see FIG. 13) of the adherent device 200, the adhesive bodies 15 may be formed in all the apertures 14 to collectively pick out the light emitting elements 71.

Alternatively, one or more of desired light emitting elements 71 may be picked out by applying an external force to the corresponding apertures 14 that face the specific light emitting elements 71, thereby producing the adhesive bodies 15 at specific positions. This scenario is illustrated in FIG. 19 (C) .

If the light emitting elements 71 are arranged on the stage 61 as they are diced from the semiconductor wafer 70, the adherent device 200 or the stage 61 may be moved relative to each other in the X-Y plane, while individually controlling the application of the external force to the aperture 14, thereby picking out the light emitting elements 71 one by one.

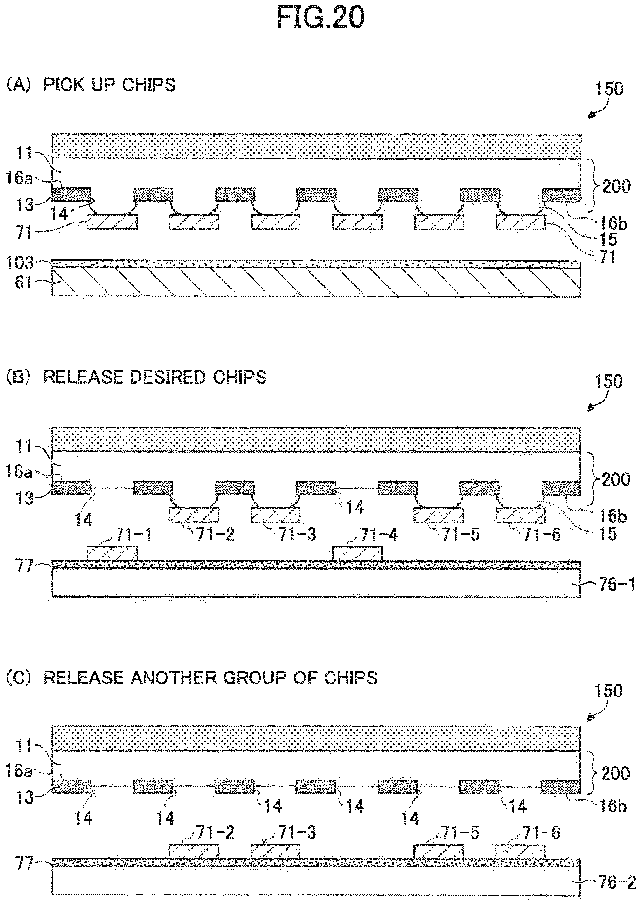

FIG. 20 shows transport of the light emitting elements 71 by the transfer equipment 150. In FIG. 20 (A), adhesive bodies 15 are formed on the second principal surface 16b of the support member 13 of the adherent device 200, and the light emitting elements 71 are collectively picked up from the stage 61.

In FIG. 20 (B), the light emitting elements 71 are held and carried to the first substrate 76-1. Above the first substrate 76-1, the external force is turned off at predetermined apertures 14, and the light emitting elements 71 of the first group (including, for example, light emitting elements 71-1 and 71-4) are placed on the first substrate 76-1 at predetermined positions. The layout pitch of the light emitting elements 71 of the first group is, for example, 0.5 mm to 2.0 mm, depending on the size of the diced light emitting element 71.

In FIG. 20 (C), the remaining light emitting elements 71 are carried to the second substrate 76-2. Above the second substrate 76-2, the external force is turned off at predetermined apertures 14, and the light emitting elements 71 of the second group (including, for example, the light emitting elements 71-2, 71-3, 71-5, and 71-6) are placed on the second substrate 76-2 at predetermined positions. If the pitch of the aperture 14 is different from the layout pitch on the second substrate 76-2, the external force applied to the respective apertures 14 may be turned off one by one, while adjusting the release positions of the light emitting elements 71 by relatively moving the second substrate 76-2 with respect to the adherent device 200 within a plane.

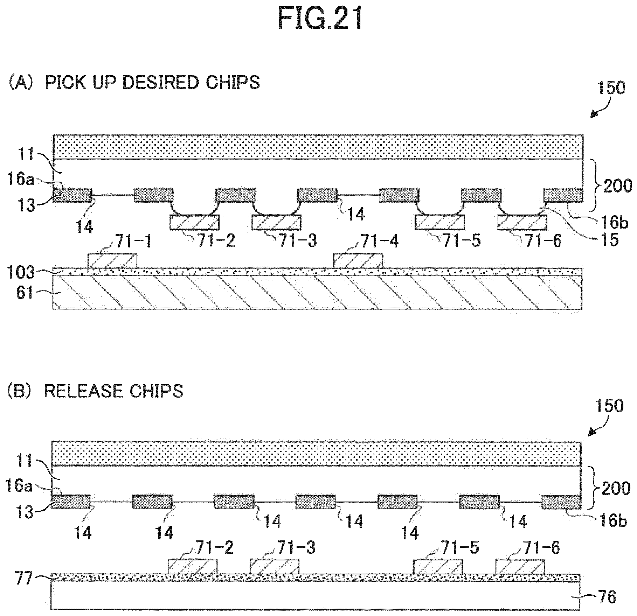

FIG. 21 shows another example of transport of light emitting elements 71 by the transfer equipment 150. In FIG. 21 (A), desired light emitting elements 71 are picked up from the stage 61 by the adhesive bodies 15. An external force is applied to the selected apertures 14 to form adhesive bodies 15 at predetermined positions on the second principal surface 16b of the support member 13. In this example, the light emitting elements 71-2, 71-3, 71-5, and 71-6 are picked out.

In FIG. 21 (B), the selected emitting elements 71-2, 71-3, 71-5, and 71-6 are carried to the target substrate 76. Above the substrate 76, the external force applied to the predetermined apertures 14 are turned off. The adhesive bodies 15 retreat from the second principal surface 16b, and the light emitting elements 71-2, 71-3, 71-5, and 71-6 are released and placed on the substrate 76. An adhesive layer 77 may be formed in advance on the surface of the substrate 76.

Using the transfer equipment 150, the adhesive strength can be easily increased or decreased at each of the apertures 14 of the adherent device 200, and objects can be efficiently transferred with a simple configuration. In addition, little adhesive remains on the transferred objects.

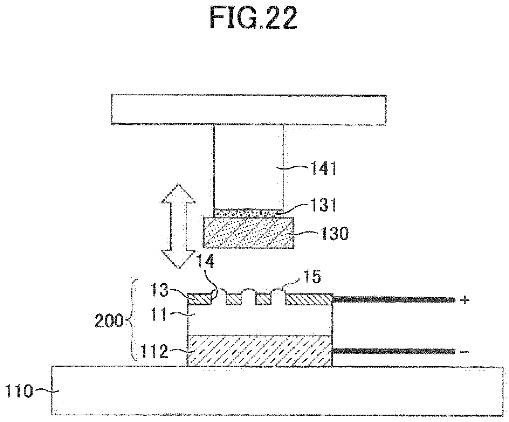

FIG. 22 is a schematic diagram of test equipment for evaluating the adhesive strength of the adherent device 200. The adherent device 200 is placed on the sample stage 110. The polymer material layer 11 is arranged between the conductive film 112 and the support member 13 made of a metal film with apertures formed therein. A voltage is applied between the support member 13 and the conductive film 112 to produce an array of adhesives bodies 15 on the surface of the support member 13.

A silicon chip 130 with a size of 5 mm × 5 mm is bonded to the tip of the terminal 141 of the test equipment by an adhesive 131 or the like. The position of the terminal 141 is controllable in the vertical direction, that is, in the direction perpendicular to the plane in which the adhesive body 115 is formed in the adherent device 200. The adhesive strength of the adherent device 200 is evaluated by pressing the silicon chip 130 against the adherent device 200 and then lifting the silicon chip 130 upward.

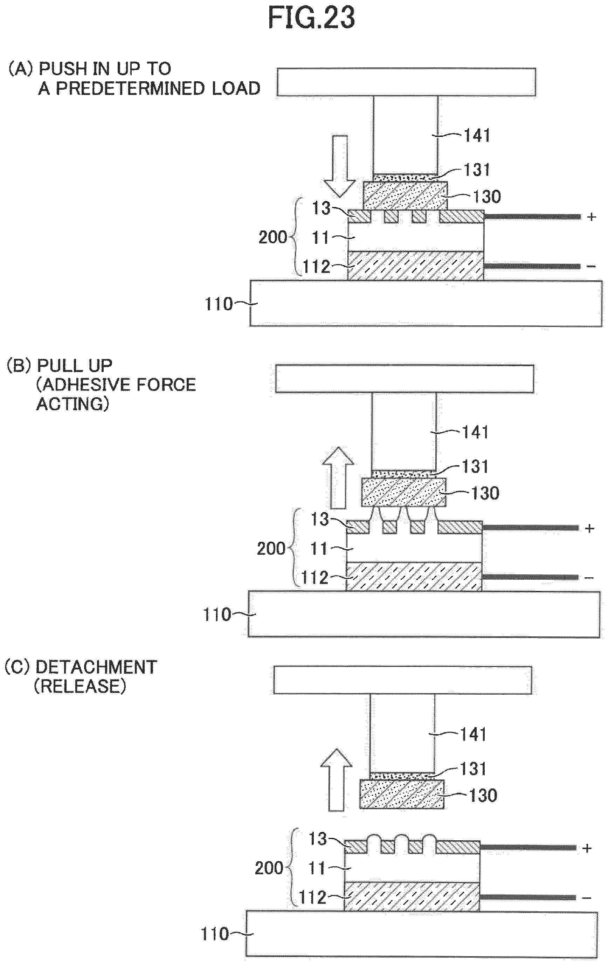

FIG. 23 shows an evaluation procedure of adhesive strength. In FIG. 23 (A), the silicon chip 130 is pressed against the surface of the adherent device 200. By applying a predetermined load to the adherent device 200, the adhesive body 115 formed on the surface of the support member 113 is pushed into the aperture of the support member 113. In this state, the silicon chip 130 adheres to the polymer material layer 11.

In FIG. 23 (B), the load (compressive stress) of the silicon chip 130 pushed against the adherent device is released. At this point of time, the compressive stress having been applied to the polymer material layer 11 since the application of the load changes to a certain level of tensile stress due to the adhesiveness of the polymer material layer 11, and adhesion is generated between the silicon chip 130 and the polymer material layer 111.

In FIG. 23 (C), when the tensile stress exceeds the limit, the silicon chip 130 is separated from the polymer material layer 11. The difference between the maximum tensile stress and the stress-free (zero load) is the adhesive force of the adherent device 200.

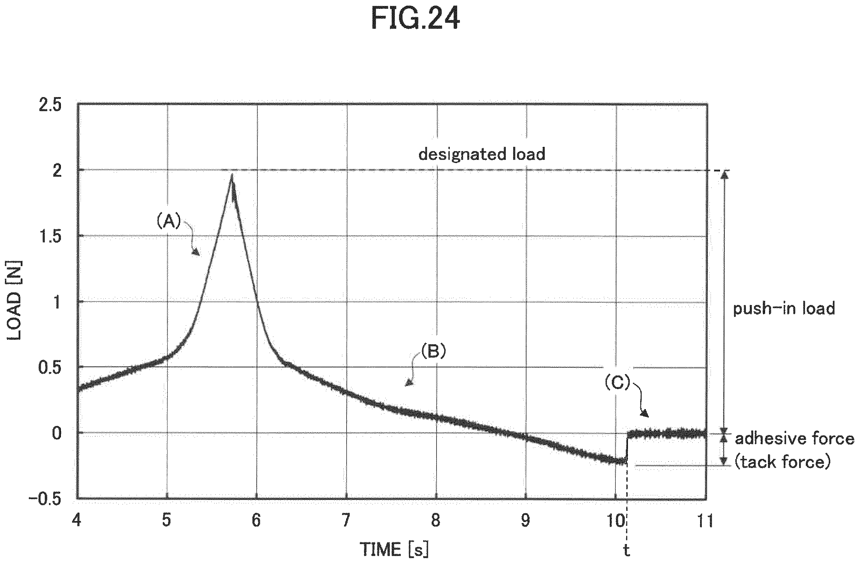

FIG. 24 shows the measurement result of the adhesive strength of the adherent device 200 acquired by the test equipment. The diameter of the adhesive body 15 formed on the surface of the support member 13 of the adherent device 200 is 100 µm. The test equipment used for the measurement is a tacking tester (JIS Z3284 compliant) manufactured by RHESCA Co., Ltd. The horizontal axis represents time (seconds), and the vertical axis represents load (N) applied from the silicon chip 130 to the adherent device 200. The load is measured by the terminal 141.

Section (A) in the figure corresponds to the process (A) of FIG. 23, in which the load applied to the adherent device 200 increases up to the designated level.

In Section (B), the load applied from the silicon chip 130 to the adherent device 200 is released from the surface of the adherent device 200. The region in which the load abruptly decreases from the peak of Section (A) represents the time section where the compressive stress is released. Subsequently, the load gradually decreases until time "t" exceeds 10 seconds, with entering into the negative domain. The negative domain indicates that the compressive stress has changed to tensile stress due to the adhesive strength of the adhesive body 15 with respect to the silicon chip 130.

In Section (C), the silicon chip 130 is peeled off from the adhesive body 15, and the load returns to zero instantaneously. The difference between the minimum value of load and zero is recorded as the adhesive strength or tack force.

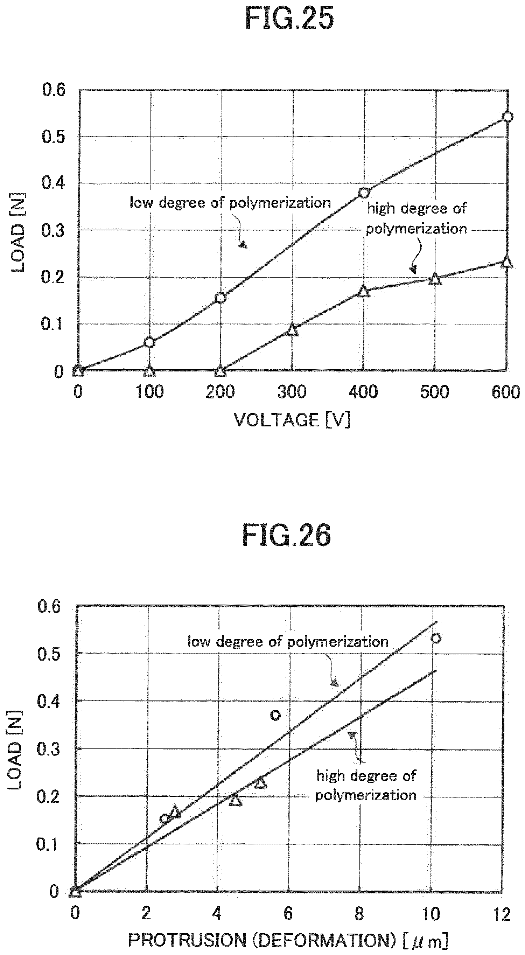

FIG. 25 shows the relationship between applied voltage and adhesive force. The horizontal axis represents the applied voltage, and the vertical axis represents the load as the adhesive force. The adhesive strength is measured using the above-described tacking tester for each of polymers in a low degree polymerization and a high degree polymerization. The polymer of low-degree polymerization is PVC gel having a molecular weight of 80,000. The polymer of high-degree polymerization is PVC gel having a molecular weight of 230,000. Each of the polymers contains 83 wt% DBA added as a plasticizer.

As the applied voltage is changed from 0 V to 600 V, the adhesive strength increases according to the increase of the applied voltage, regardless of the degree of polymerization. Comparing between the polymers in a high degree of polymerization and a low degree of polymerization, a lower-degree polymerization polymer has a higher adhesive strength at the same level of applied voltage. It is assumed that, with a high degree of polymerization, the polymer chains are less likely to be entangled, and that the adhesive strength with respect to the silicon chip is lower than that of a low-degree polymerization polymer.

If a voltage is employed as the external force to be applied to the adherent device, the adhesive strength of the adherent device can be controlled by regulating the voltage. In the application of the adherent device to the transfer equipment 150, an appropriate adhesive strength can be imparted to the adherent device according to the size, weight, shape, etc. of the object to be transferred. The adhesive strength of the adherent device also depends on the adhesiveness of the polymer material used. Therefore, by properly designing the combination of the polymer material and the voltage to be applied, the optimum adhesive strength can be determined depending on the object to be transferred.

FIG. 26 shows the relationship between the amount of protrusion of the adhesive body 15 and the adhesive force at an aperture with a diameter of 100 µm. The amount of protrusion of the adhesive 15 depends not only on the applied voltage, but also on the size of the aperture 14 formed in the support member 13, as well as the elastic modulus of the polymer material. The greater the amount of protrusion of the adhesive body 15, the higher the adhesive strength. By optimally designing the size of the aperture 14 of the support member 13 in combination with the polymer material and the applied voltage, transport of the object can be controlled more accurately.

In an example, a Si wafer is temporarily fixed with a dicing tape and cut into 5 mm × 5 mm chips. For the dicing tape, a back grind tape manufactured by Nitto Denko Corporation is used. The width of the back grind tape is 20 mm specified by the JIS standard.

After the dicing, the dicing tape is heated at 100°C to 120°C for 1 minute to reduce the adhesion. By this heating, the adhesive strength of the dicing tape is reduced to less than 0.2 N/20 mm. Converting this value to a silicon-chip size, the adhesive strength becomes less than about 0.04 N/5 mm.

For the adherent device 200, in order to separate and pick up the silicon chip from the dicing tape, the adhesive body 15 should have an adhesive strength of 0.04 N or more. If a low-degree polymerization polymer of FIG. 25 is used, the silicon chip can be picked by applying a voltage of 100 V. If a high-degree polymerization polymer is used, a voltage of 250 V can be applied to pick up the same silicon chip from the dicing tape.

From FIG. 26, the silicon chip can be picked up from the dicing tape by causing the adhesive body 15 to protrude at a height of about 1 µm on the surface of the support member 13. A higher degree polymerization polymer requires a higher voltage to achieve the same height of the protrusion, compared with a lower degree polymerization polymer. By appropriately selecting the polymer material to be used and the size of the aperture 14 of the support member 13, the voltage applied for imparting an adhesive strength of a required level can be minimized.

The adherent device of the embodiment can selectively hold or release an object, and it can be used repeatedly. Little adhesive remains on the object, regardless of the type and properties of the object to be held. In the case of employing an individual control configuration for each aperture, the adhesive strength can be varied only in a desired area. As a result, efficient transport is achieved.

The present application is based upon and claims priority to the earlier Japanese Patent Application No. 2019-035199 filed February 28, 2019 and Japanese Patent Application No. 2020-26323 filed February 19, 2020, the entireties of which are herein incorporated.

### Listing of Symbols

10, 10A-10E, 80, 90: adherent device
11, 81, 91: polymer material layer
12, 112: conductive film
13, 83, 93: support member
14, 84, 94: aperture
15, 85: adhesive body
95: protrusion
16a: first principal surface
16b: second principal surface
50: transfer equipment
100, 200, 200A-200C: adherent device (of array type)

## Claims

1. An adherent device comprising:
a support member having at least one aperture; and
a polymer material layer provided on a side of a first principal surface of the support member, wherein an adhesive strength on a second principal surface on a side opposite the first principal surface of the support member varies by application of an external force.

2. The adherent device as claimed in claim 1,
wherein the polymer material layer is an adherent polymer layer, and
wherein an adhesive body is provided on the second principal surface by application of the external force.

3. The adherent device as claimed in claim 2,
wherein the adhesive body retreats from the second principal surface to the first principal surface when the external force is turned off.

4. The adherent device as claimed in claim 1,
wherein the polymer material layer is an adherent polymer layer,
wherein an adhesive body is provided on the second principal surface without application of the external force, and
wherein the adhesive body retreats from the second principal surface to the first principal surface by application of the external force.

5. The adherent device as claimed in claim 1,
wherein the support member is an adherent support member, and the polymer material layer is a non-adherent polymer layer or a low-adherent polymer layer with an adhesiveness lower than the adherent support member, and
wherein a polymer protrusion is produced on the second principal surface by application of the external force.

6. The adherent device as claimed in claim 2 or 3, further comprising:
a conductive film provided around the aperture,
wherein the adhesive body is reversibly produced on the second principal surface by application of a voltage via the conductive film to the polymer material layer.

7. The adherent device as claimed in claim 2 or 3,
wherein the support member is formed of a conductive material, and
wherein the adhesive body is reversibly produced on the second principal surface by application of a voltage via the support member to the polymer material layer.

8. The adherent device as claimed in claim 6 or 7,
wherein an adhesive strength of the adhesive body is variable according to an applied voltage level.

9. The adherent device as claimed in claim 2 or 3, further comprising:
a thermally conductive layer surrounding the aperture,
wherein the adhesive body is reversibly produced on the second principal surface by application of heat via the thermally conductive layer to the polymer material layer.

10. The adherent device as claimed in claim 2 or 3,
wherein the support member is formed of a thermally conductive material, and
wherein the adhesive body is reversibly produced on the second principal surface by application of heat via the support member to the polymer material layer.

11. The adherent device as claimed in claim 2 or 3, further comprising:
a pressure control means configured to increase or decrease a pressure applied to the polymer material layer,
wherein the adhesive body is reversibly produced on the second principal surface by application of the pressure to the polymer material layer.

12. The adherent device as claimed in any one of claims 1 to 11,
wherein the support member has a plurality of apertures, and
wherein application of the external force is controllable independently for each of the apertures.

13. A transfer equipment comprising:
an adherent device which has a support member with at least one aperture, and a polymer material layer provided on a side of a first principal surface of the support member, an adhesive strength on a second principal surface on a side opposite the first principal surface of the support member being varied by application of an external force;
a driving mechanism configured to move the adherent device between a first position and a second position; and
a controller that controls a timing of application of the external force, thereby changing the adhesive strength of the second principal surface of the support member between the first position and the second position to transport an object between the first position and the second position.

14. The transfer equipment as claimed in claim 13,
wherein the adherent device has an adhesive body produced on the second principal surface by application of the external force, and
wherein the controller applies the external force at the first position to hold the object by the adhesive body, and turns off the external force at the second position to release the object.

15. The transfer equipment as claimed in claim 14,
wherein the controller causes a plurality of adhesive bodies to be produced at the first position to hold a plurality of objects, and
wherein the controller turns off the external force for a part of the plurality of adhesive bodies included in a first group of adhesive bodies at the second position to release a part of the plurality of objects included in a first group of objects, and turns off the external force for another part of the plurality of adhesive bodies included in a second group of adhesive bodies, independently from the part of the plurality of adhesive bodies of the first group of adhesive bodies, to release another part of the plurality of objects included in a second group of objects at a layout position different from that of the first group of objects.

16. The transfer equipment as claimed in claim 14 or 15,
wherein the external force is a voltage, and the adhesive strength of the plurality of adhesive bodies is varied according to a voltage level.

17. A transfer method comprising:
using an adherent device which has a support member with at least one aperture, and a polymer material layer provided on a side of a first principal surface of the support member, an adhesive strength of a second principal surface on a side opposite the first principal surface being varied by applying an external force;
changing the adhesive strength of the second principal surface at a first position and a second position; and
transporting an object between the first position and the second position by means of a change in the adhesive strength.

18. The transfer method as claimed in claim 17, comprising:
applying the external force to the adherent device at the first position to produce the adhesive body on the second principal surface;
holding the object by the adhesive body to transport the object from the first position to the second position; and
turning off the external force at the second position to release the object.

19. The transfer method as claimed in claim 18, comprising:
producing a plurality of adhesive bodies on the second principal surface at the first position;
holding a plurality of objects by the plurality of adhesive bodies to transporting the plurality of objects to the second position;
turning off the external force for a part of the plurality of adhesive bodies included in a first group of adhesive bodies at the second position to release a part of the plurality of objects included in a first group of objects; and
turning off the external force for another part of the plurality of adhesive bodies included in a second group of adhesive bodies, independently from the part of the plurality of adhesive bodies of the first group of adhesive bodies, to release another part of the plurality of objects included in a second group of objects at a layout position different from that of the first group of objects.

20. The transfer method as claimed in claim 18 or 19, comprising:
applying a voltage as the external force; and
controlling a voltage level to change the adhesive strength of the plurality of adhesive bodies.
